(19) Europäisches Patentamt / European Patent Office / Office européen des brevets

(11) **EP 1 476 878 B1**

(12) **FASCICULE DE BREVET EUROPEEN**

(45) Date de publication et mention
de la délivrance du brevet:
**05.05.2010 Bulletin 2010/18**

(21) Numéro de dépôt: **03739527.4**

(22) Date de dépôt: **11.02.2003**

(51) Int Cl.:
***G11C 17/14*** *(2006.01)*

(86) Numéro de dépôt international:
**PCT/FR2003/000446**

(87) Numéro de publication internationale:
**WO 2003/069630 (21.08.2003 Gazette 2003/34)**

(54) **CELLULE MEMOIRE A PROGRAMMATION UNIQUE NON DESTRUCTRICE**

ZERSTÖRUNGSFREIE EINMAL PROGRAMMIERBARE SPEICHERZELLE

MEMORY CELL WITH NON-DESTRUCTIVE ONE-TIME PROGRAMMING

(84) Etats contractants désignés:
**DE FR GB IT**

(30) Priorité: **11.02.2002 FR 0201637**
**29.10.2002 FR 0213555**

(43) Date de publication de la demande:
**17.11.2004 Bulletin 2004/47**

(73) Titulaire: **STMicroelectronics S.A.**
**92120 Montrouge (FR)**

(72) Inventeurs:
• **WUIDART, Luc**
**F-83190 Pourrières (FR)**
• **BARDOUILLET, Michel**
**F-13790 Rousset (FR)**
• **MALHERBE, Alexandre**
**F-13530 Trets (FR)**

(74) Mandataire: **de Beaumont, Michel**
**Cabinet Michel de Beaumont**
**1, rue Champollion**
**38000 Grenoble (FR)**

(56) Documents cités:
EP-A- 0 511 560      EP-A- 0 753 859
FR-A- 2 523 357      GB-A- 2 084 828
US-A- 4 146 902      US-A- 4 342 102
US-A- 4 399 372      US-A- 4 449 203
US-A- 4 476 478      US-A- 4 590 589
US-A- 5 440 505      US-A- 5 504 760
US-A- 5 689 455      US-A- 5 761 118
US-A- 5 926 409      US-A- 5 936 880
US-B1- 6 198 678

• **PATENT ABSTRACTS OF JAPAN vol. 003, no. 121 (E-143), 11 octobre 1979 (1979-10-11) & JP 54 098536 A (NIPPON TELEGR & TELEPH CORP), 3 août 1979 (1979-08-03)**

# EP 1 476 878 B1

**Description**

La présente invention concerne le domaine des cellules mémoire à programmation unique (OTP) et, plus particulièrement, la réalisation d'une mémoire à programmation unique en circuit intégré.

Classiquement, les mémoires à programmation unique en circuit intégré sont de type EPROM et requièrent donc des circuits de programmation spécifiques qui ne sont pas compatibles avec les technologies standard de fabrication des transistors MOS utilisés dans les circuits intégrés. On trouve aussi des mémoires à programmation unique réalisées par des EEPROM et des mémoires flash non effaçables.

Une autre catégorie de mémoires à programmation unique est constituée des mémoires fusibles ou anti-fusibles. Parmi celles-ci, on trouve des mémoires formées d'un barreau ou piste de silicium polycristallin que l'on soumet à un courant très élevé de façon à détériorer physiquement le silicium polycristallin et ouvrir le circuit. De telles cellules mémoires à programmation unique requièrent des courants très élevés (de l'ordre de la centaine de milliampères). Cela limite considérablement leur utilisation. De plus, la programmation opérée sur une cellule de type fusible est visible optiquement, ce qui nuit à la sécurité d'un code binaire enfoui dans un circuit intégré et masqué dans une mémoire à programmation unique.

Un inconvénient similaire existe avec les mémoires de type EPROM ou EEPROM, à savoir qu'une détection de l'état des cellules de mémorisation est possible au moyen d'un microscope à balayage électronique qui peut détecter la différence de charges accumulées dans les transistors à grille flottante de telles mémoires.

La présente invention vise à proposer une nouvelle structure de cellule mémoire à programmation unique qui pallie les inconvénients des structures connues.

L'invention vise plus particulièrement à proposer la réalisation d'une cellule mémoire en circuit intégré qui ne requiert aucune étape de fabrication supplémentaire par rapport aux étapes mises en oeuvre pour la fabrication de transistors MOS dans les technologies classiques.

L'invention vise également à améliorer la sécurité d'un code enfoui au moyen d'une cellule mémoire à programmation unique.

L'invention vise également à proposer une cellule mémoire peu onéreuse.

L'invention vise également à proposer une mémoire à programmation unique. Le préambule de la revendication 1 est décrit par le document EP 0 511 560.

Le document JP-A-54 098536 décrit une cellule-mémoire comprenant un transistor en série avec une résistance en silicium polycristallin dont la résistance est modifiée pour programmer la cellule.

Le document FR-A-2 523 357 décrit une mémoire associée à un amplificateur de lecture comparant le courant dans une branche de référence par rapport à une branche sélectionnée d'un réseau matriciel de cellule-mémoires.

Le document US-A-4 146 902 décrit une cellule-mémoire à programmation unique comportant un transistor en série avec une résistance en silicium polycristallin programmée par un courant dans cette résistance.

Le document US-B-6 198 678 décrit une mémoire et son amplificateur de lecture.

Pour atteindre ces objets et d'autres, l'invention prévoit une cellule mémoire à programmation unique telle que définie par la revendication 1.

Selon un mode de réalisation de la présente invention, le potentiel de référence est prélevé au point milieu d'un pont diviseur résistif.

Selon un mode de réalisation de la présente invention, chaque cellule présente un état non programmé qui est, par programmation, modifié en diminuant, de façon irréversible et stable dans la plage de courants de fonctionnement en lecture de la cellule, la valeur de sa résistance en silicium polycristallin.

Selon un mode de réalisation de la présente invention, la programmation d'une cellule est commandée en forçant la circulation d'un courant dans sa résistance en silicium polycristallin qui soit supérieur au courant pour lequel la valeur de cette résistance présente un maximum.

Selon un mode de réalisation de la présente invention, plusieurs amplificateurs de lecture reçoivent des tensions de références différentes et sont tous connectés par leur première entrée à plusieurs cellules, de façon à constituer une mémoire multi-niveaux différenciés par les valeurs des résistances en silicium polycristallin.

- Ces objets, caractéristiques et avantages, ainsi que d'autres de la présente invention seront exposés en détail dans la description suivante de modes de mise en oeuvre et de réalisation particuliers, faite à titre non-limitatif en relation avec les figures jointes parmi lesquelles :

la figure 1 représente un premier exemple de réalisation d'une cellule mémoire à programmation unique ;
la figure 2 représente un deuxième exemple mode de réalisation d'une cellule mémoire à programmation unique ;
la figure 3 illustre, par une vue partielle en perspective, un mode de réalisation d'une résistance en silicium polycristallin constituant l'élément de mémorisation d'une cellule selon l'invention ;
la figure 4 illustre, par un réseau de courbes, la programmation d'une cellule mémoire selon la présente invention ;

la figure 5 représente un mode de réalisation d'une mémoire multicellulaire selon la présente invention ; et
la figure 6 représente un exemple de réalisation d'une mémoire.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les circuits exploitant les codes binaires au moyen de cellules selon l'invention n'ont pas été détaillés. L'invention pourra être mise en oeuvre quelle que soit l'utilisation faite du code mémorisé.

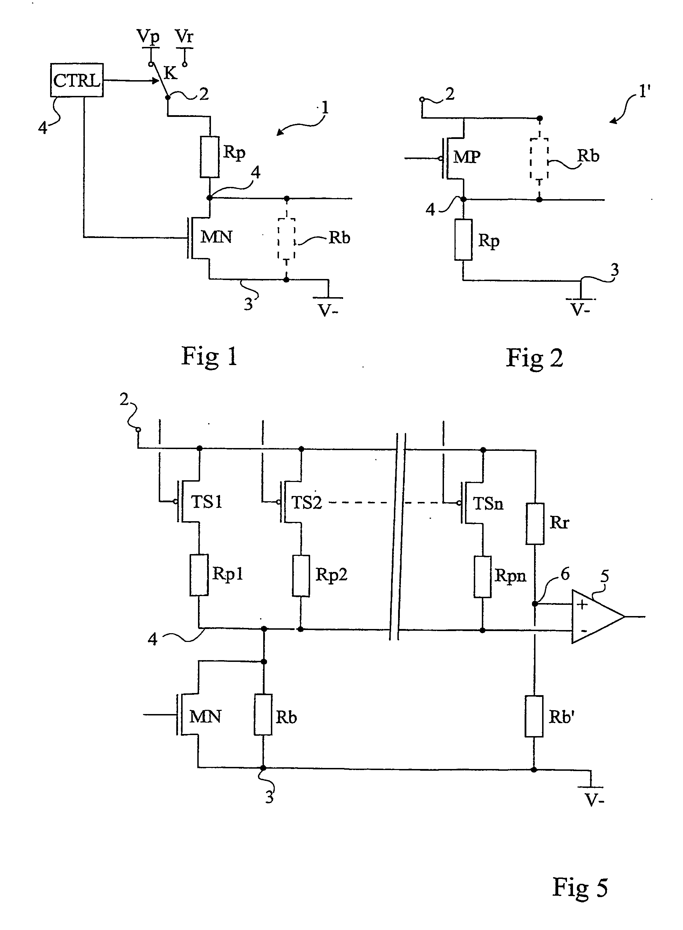

La figure 1 représente un premier exemple de réalisation d'une cellule mémoire à programmation unique.

La cellule mémoire 1 comporte, en série avec une première borne 2 d'application d'un potentiel positif d'alimentation et une deuxième borne 3 d'application d'un potentiel plus négatif d'alimentation V- ou de référence (généralement la masse), une résistance programmable Rp et un interrupteur de programmation (ici, un transistor MOS à canal N MN). La résistance Rp constitue l'élément de mémorisation de la cellule 1. L'état stocké dans la cellule est lu sur le point milieu 4 de l'association en série de la résistance Rp avec le transistor MN. La lecture du niveau mémorisé s'effectue comme on le verra par la suite en relation avec la figure 5, par comparaison par rapport à un niveau de référence.

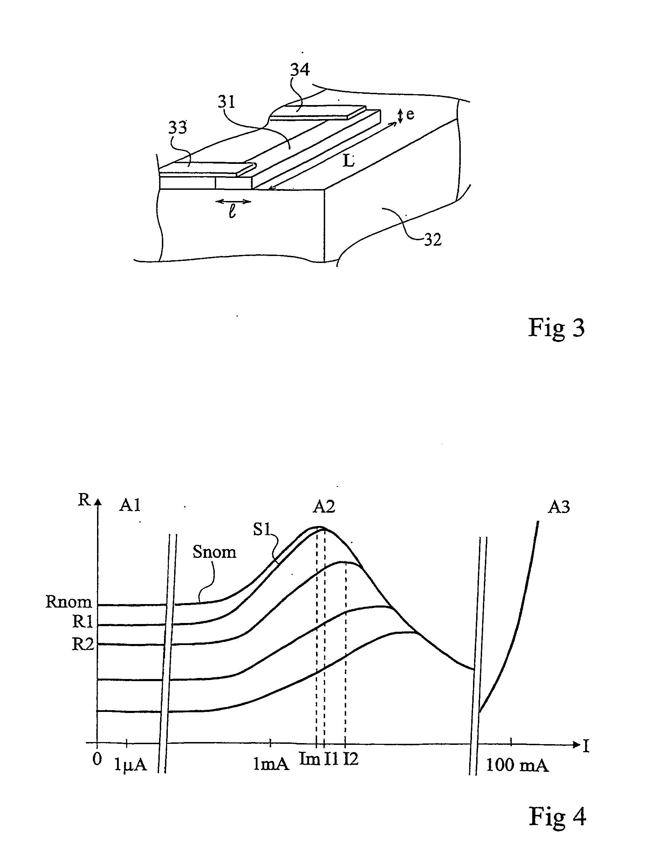

Une caractéristique est que la résistance Rp constituant l'élément de mémorisation est une résistance en silicium polycristallin dont la valeur est programmable par diminution irréversible de sa valeur, comme cela sera exposé par la suite en relation avec les figures 3 et 4.

Selon cet exemple de réalisation, pour permettre la lecture de l'état mémorisé dans la cellule 1, on prévoit une résistance Rb (représentée en pointillés en figure 1) qui, lorsque le transistor MN est ouvert constitue avec la résistance Rp un diviseur de tension. La résistance Rb a été représentée en pointillés pour illustrer son caractère optionnel. En effet, celle-ci pourra être constituée par le transistor MN alors polarisé dans une partie linéaire de sa caractéristique et non en saturation.

Le transistor MN, lorsqu'il est passant, court-circuite (au moins fonctionnellement) la résistance fixe Rb et sert à programmer la résistance Rp en imposant la circulation d'un courant dans celle-ci. Le courant de programmation de la résistance Rp est supérieur au courant pour lequel cette résistance présente une valeur maximale. Cette caractéristique ressortira mieux de la description qui sera faite par la suite en relation avec les figures 3 et 4. Pour l'instant, on se contente de noter que si la résistance Rp est soumise à un courant supérieur au courant pour lequel sa valeur est maximale, on assiste à une diminution irréversible de la valeur de sa résistance lorsque l'on revient à des courants situés dans la plage nominale de fonctionnement. La plage nominale des courants de fonctionnement d'une résistance en silicium polycristallin utilisée selon l'invention est inférieure à la centaine de microampères et, le plus souvent, inférieure à la dizaine de microampères. L'amplitude des courants de programmation est de l'ordre du milliampère.

La programmation d'une cellule telle qu'illustrée par la figure 1 est rendue possible en prévoyant une sélection du potentiel positif d'alimentation appliquée à la borne 2 entre un potentiel Vr de lecture (propre à engendrer un courant de l'ordre du microampère) et un potentiel Vp de programmation (propre à engendrer une courant de l'ordre du milliampère). La sélection est opérée au moyen d'un interrupteur K commandé par un circuit 4 de commande (CTRL) fournissant, par ailleurs, le signal de commande adapté au transistor MN.

La figure 2 représente un deuxième exemple de réalisation d'une cellule mémoire 1'. Cette cellule diffère de la cellule de la figure 1 par le fait que le transistor de programmation utilisé est un transistor MOS à canal P MP. Le transistor MOS à canal P est connecté entre la borne 2 et le point 4 de lecture. La résistance de programmation Rp est connectée entre le point 4 et la borne 3 d'application du potentiel de référence. En figure 2, l'interrupteur K et le circuit de commande 4, bien que toujours présents, n'ont pas été représentés. La résistance Rb en pointillés a été symbolisée en parallèle sur le transistor MP.

Le fonctionnement d'une cellule 1' telle que représentée en figure 2 est similaire à celui de la cellule 1 de la figure 1. Cette dernière constitue cependant un exemple de réalisation préféré en raison du moindre encombrement du transistor MOS à canal N par rapport au transistor MOS à canal P.

La figure 3 représente un mode de réalisation d'une résistance en silicium polycristallin constituant un élément de mémorisation Rp d'une cellule caractéristique de l'invention.

Une telle résistance (désignée par 31 en figure 3) est constituée d'une piste (dite aussi barreau) en silicium polycristallin obtenue par gravure d'une couche déposée sur un substrat 32 isolant. Le substrat 32 est indifféremment directement constitué du substrat du circuit intégré ou est constitué d'une couche isolante formant un substrat isolant ou équivalent pour la résistance 31. La résistance 31 est connectée, par ses deux extrémités, à des pistes conductrices (par exemple, métalliques) 33 et 34 destinées à raccorder le barreau résistif aux autres éléments du circuit intégré. La représentation schématique de la figure 3 ne fait pas référence aux différentes couches isolantes et conductrices constituant généralement le circuit intégré. Pour simplifier, on s'est contenté de représenter le barreau résistif 31 posé sur le substrat isolant 32 et en contact, par les extrémités de sa face supérieure, avec les deux pistes métalliques 33 et 34. En pratique, les liaisons de l'élément résistif 31 aux autres composants du circuit intégré sont obtenues par des pistes plus larges en silicium polycristallin partant des extrémités du barreau 31 dans l'alignement de celui-ci. En d'autres termes, l'élément résistif 31 est généralement formé en rendant un tronçon d'une piste en silicium polycristallin plus étroit que le reste de la piste.

La résistance R de l'élément 31 est donnée par la formule suivante :

$$R = \rho(L/s),$$

où p désigne la résistivité du matériau (silicium polycristallin le cas échéant dopé) constituant la piste dans laquelle est gravé l'élément 31, où L désigne la longueur de l'élément 31, et où s désigne sa section, c'est-à-dire sa largeur 1 par son épaisseur e. La résistivité p de l'élément 31 dépend, entre autres, du dopage éventuel du silicium polycristallin le constituant.

Le plus souvent, lors de la réalisation d'un circuit intégré, on prévoit les résistances en faisant référence à une notion dite de résistance par carreau $R_\square$ (square resistance). Cette résistance par carreau se définit comme étant la résistivité du matériau divisée par l'épaisseur avec laquelle il est déposé. En reprenant la relation ci-dessus donnant la résistance d'un élément 31, la résistance est donc donnée par la relation :

$$R = R_\square * L/l.$$

Le quotient L/1 correspond à ce que l'on appelle le nombre de carreaux (square number) constituant l'élément résistif 31. Cela représente, vu de dessus, le nombre de carreaux de dimension donnée fonction de la technologie, mis côte à côte pour former l'élément 31.

La valeur de la résistance en silicium polycristallin est donc définie, à la fabrication, d'après les paramètres ci-dessus, conduisant à des résistivités et résistances dites nominales. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Une caractéristique de la présente invention est d'imposer temporairement, dans une résistance en silicium polycristallin (Rp) dont on souhaite diminuer irréversiblement la valeur, un courant de programmation ou de contrainte supérieur à un courant pour lequel la résistance passe par une valeur maximale, ce courant étant au-delà de la plage de courants de fonctionnement normal (en lecture) de cette résistance. En d'autres termes, on diminue la résistivité du silicium polycristallin dans la plage de courants de fonctionnement, de façon stable et irréversible, en imposant temporairement dans l'élément résistif correspondant la circulation d'un courant au-delà de la plage de courants de fonctionnement.

Une autre caractéristique de l'invention est que le courant servant à diminuer la valeur de la résistance est, à la différence d'un élément fusible, non destructif pour l'élément en silicium polycristallin.

La figure 4 illustre, par un réseau de courbes donnant la résistance d'un élément en silicium polycristallin du type de celui représenté en figure 3 en fonction du courant le traversant, un mode de mise en oeuvre de la présente invention pour programmer la résistance de la cellule mémoire.

On suppose que le silicium polycristallin ayant servi à la fabrication de l'élément résistif 31 (Rp) présente une résistivité nominale conférant à l'élément 31, pour les dimensions 1, L et e données, une valeur de résistance $R_{nom}$. Cette valeur nominale (d'origine) de la résistance correspond à la valeur prise de façon stable par l'élément résistif 31 dans la plage de courants de fonctionnement du système, c'est-à-dire généralement pour des courants inférieurs à 100 μA.

Selon l'invention, pour diminuer la valeur de la résistance et passer de façon irréversible et stable, par exemple, à une valeur R1 inférieure à $R_{nom}$, on applique aux bornes de l'élément résistif 31 un courant (par exemple I1), dit de contrainte, supérieur à un courant Im pour lequel la valeur de la résistance R de l'élément 31 est maximale sans toutefois être infinie. Comme l'illustre la figure 4, une fois que ce courant I1 a été appliqué à l'élément résistif 31, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 μA). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 4, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique de programmation, hors du fonctionnement normal en lecture (plage A1) du circuit intégré, c'est-à-dire hors du fonctionnement normal de la résistance.

Le cas échéant, une fois que la valeur de la résistance en silicium polycristallin a été abaissée vers une valeur inférieure (par exemple R1 en figure 4), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$. Dans l'application aux cellules mémoires des figures 1 et 2, cela montre le caractère irréversible de la programmation apportée. Une tentative de sur-programmation ne fait qu'accroître la diminution de la valeur de la résistance par rapport à sa valeur nominale, donc ne fait que confirmer la programmation initiale.

On voit que toutes les allures de la résistance en fonction du courant se rejoignent sur la pente de décroissance de la valeur de la résistance, après être passé par le maximum de l'allure. Ainsi, pour un élément résistif donné (p, L, s), les courants I1, I2, etc. qui doivent être atteints, pour passer à une valeur de résistance inférieure, sont indépendants de la valeur de la résistance (Rnom, R1, R2) à partir de laquelle on provoque la diminution. En fait, le courant provoque une élévation de la température de l'élément en silicium polycristallin, ce qui entraîne son fluage.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint.

Bien sûr, on veillera à ne pas dépasser la plage de courants de programmation A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin selon l'invention ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 3, on réalisera des vias dans l'isolant surjacent (non représenté) du barreau de silicium polycristallin pour connecter des pistes métalliques 33 et 34 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes données. En d'autres termes, pour un élément de dimensions données, cela conditionne le point de départ de la valeur de la résistance, et par voie de conséquence, les valeurs de résistance obtenues pour des courants de contrainte donnés.

Pour passer de la valeur nominale à une valeur de résistance ou résistivité inférieure, on peut selon l'invention utiliser plusieurs méthodes.

Selon un premier mode de mise en oeuvre, on fait croître progressivement (pas à pas) le courant dans la résistance. Après chaque application d'un courant supérieur, on revient dans la plage de courants de fonctionnement et on mesure la valeur de la résistance. Tant que le point Im de courant n'est pas atteint, cette valeur de résistance restera à la valeur $R_{nom}$. Dès que le point Im en courant est dépassé, on change de courbe (allure S) et la valeur mesurée lorsque l'on repasse sur les courants de fonctionnement devient une valeur inférieure à la valeur $R_{nom}$. Si cette nouvelle valeur convient, on en reste là. Dans le cas contraire, on réapplique des courants supérieurs pour dépasser la nouvelle valeur maximale de l'allure courante. Dans ce cas, il n'est pas nécessaire de repartir des courants minimaux comme lorsque l'on démarre de la résistance nominale. En effet, la valeur du courant pour laquelle la résistance va de nouveau diminuer est forcément supérieure à la valeur du courant de contrainte I1 appliqué pour passer sur l'allure courante. La détermination du pas à appliquer est à la portée de l'homme du métier et n'est pas critique en ce qu'elle conditionne essentiellement le nombre de diminutions possibles. Plus le pas est élevé, plus les sauts entre les valeurs seront importants.

Selon un deuxième mode de mise en oeuvre, on prédétermine, par exemple par mesures, les différents courants à appliquer pour passer des différentes valeurs de résistance à des valeurs inférieures. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 4 peuvent également être lues comme allure de la résistance par carreau, on est en mesure de transposer les valeurs calculées aux différentes résistances d'un circuit intégré définies par les largeurs et longueurs des tronçons résistifs. Selon ce deuxième mode de mise en oeuvre, on est alors en mesure de prédéterminer la valeur du courant de contrainte à appliquer à l'élément résistif pour diminuer, de façon irréversible et stable, sa valeur.

Les deux modes de mise de oeuvre ci-dessus peuvent être combinés. On peut ainsi, dans une première étape, sélectionner une valeur approximative (dans une table) et appliquer le courant prédéterminé correspondant. Puis, dans une deuxième étape, on affine la valeur de la résistance par des diminutions pas à pas de sa valeur.

Selon l'invention, la diminution irréversible de la résistance ou résistivité peut être effectuée après fabrication lorsque le circuit est dans son environnement fonctionnel. En d'autres termes, le circuit 4 de commande et les transistors de programmation décrits en relation avec les figures 1 et 2 peuvent être intégrés avec la ou les cellules mémoires.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si dans une application particulière on considère ne pas pouvoir négliger l'influence de la durée d'application de la contrainte, les deux modes préférés de mise en oeuvre (prédéterminer des valeurs de contraintes en durée et en intensité, ou progression pas à pas jusqu'à la valeur souhaitée) sont parfaitement compatibles avec la prise en compte de la durée d'application de la contrainte.

A titre d'exemple particulier de mise en oeuvre, on a réalisé une résistance en silicium polycristallin dopée N+ ayant une section de 0,225 micromètre carré (1 = 0,9 $\mu$m, e = 0,25 $\mu$m) et une longueur L de 45 micromètres. Avec le silicium polycristallin utilisé et le dopage correspondant, la résistance nominale était d'environ 6300 Ohms. Cela correspond à une résistance par carreau d'environ 126 Ohms (50 carreaux). En appliquant à cette résistance un courant supérieur à trois milliampères, on a provoqué une diminution de sa valeur, stable pour un fonctionnement sous des courants allant jusqu'à 500 microampères. Avec un courant de 3,1 milliampères, la valeur de la résistance a été abaissée à environ 4500 Ohms. En appliquant à la résistance un courant de 4 milliampères, on a diminué la valeur de la résistance jusqu'environ 3000 Ohms. Les valeurs obtenues de résistances ont été les mêmes pour des durées de contraintes allant de 100 microsecondes à plus de 100 secondes.

Selon un exemple de mise en oeuvre particulier de l'invention, le courant de contrainte est compris entre 1 et 10 milliampères.

Toujours selon un exemple de mise en oeuvre particulier, la concentration en dopant du silicium polycristallin est comprise entre $1.10^{13}$ et $1.10^{16}$ atomes par centimètre cube.

A titre d'exemple particulier, on a réalisé des résistances en silicium polycristallin ayant les caractéristiques nominales suivantes.

| type de silicium polycristallin | cristallin | cristallin | amorphe |
|---|---|---|---|
| technologie | 0,18 $\mu$m, | 0,18 $\mu$m | 0,35 $\mu$m |
| largeur | 0,5 $\mu$m | 0,5 $\mu$m | 0,9 $\mu$m |
| longueur | 3,4 $\mu$m | 80 $\mu$m | 45 $\mu$m |
| épaisseur | 200 nm | 200 nm | 250 nm |
| résistance/carreau | 80 ohms/$\square$ | 100 ohms/$\square$ | 115 ohms/$\square$ |
| résistance globale | 556 ohms | 16000 ohms | 5750 ohms |
| concentration de dopant (atomes/cm3) | As = $6.10^{15}$ | As = $5.10^{15}$ | P = $1.10^{13}$ As = $4.10^{15}$ |
| courant de contrainte pour diminuer la résistance de moitié | 5,5 mA | 4,8 mA | 2,75 mA |

Bien entendu, les exemples ci-dessus ainsi que les ordres de grandeurs donnés de courants et de résistances pour les différentes plages concernent les technologies actuelles. Les courants des plages A1, A2 et A3 pourront être différents (inférieurs) pour des technologies plus avancées et peuvent être transposés à des densités de courant. Le principe de l'invention n'en est pas modifié. On a toujours trois plages et on utilise la plage intermédiaire pour forcer la diminution de résistivité.

La tension de programmation Vp peut être une tension variable selon que les niveaux de courant de programmation sont prédéterminés ou sont inconnus et doivent être obtenus par une augmentation par paliers.

Selon une variante de réalisation, le courant de programmation forcé dans la résistance Rp est fixé par la commande (tension de grille) du transistor de programmation correspondant, la tension Vp étant alors fixe.

Un premier avantage est qu'une cellule mémoire réalisée au moyen d'une résistance en silicium polycristallin programmable par diminution irréversible de sa valeur est compatible avec les technologies classiques de réalisation des transistors MOS. En particulier, aucun transistor à grille flottante n'est nécessaire pas plus que de structure tunnel comme pour la réalisation d'une mémoire EPROM.

Un autre avantage est que le code stocké dans l'élément de mémorisation n'est pas détectable optiquement à la différence d'une résistance en silicium polycristallin utilisée comme fusible où la détérioration physique du barreau de silicium rend la programmation visible.

Un autre avantage est que la modification irréversible de la valeur de la résistance programmée n'est pas destructrice et ne risque donc pas d'endommager d'autres parties du circuit. Cela permet notamment de prévoir une diminution de la valeur de la résistance après fabrication, et même au cours de sa vie dans son circuit applicatif.

La figure 5 représente le schéma électrique d'une mémoire selon un mode de réalisation de l'invention, associant plusieurs cellules du type de celle représentée en figure 1.

Selon ce mode de réalisation, on prévoit n éléments de mémorisation Rp1, Rp2, ..., Rpn. Toutes les résistances de programmation Rpi sont individuellement reliées par un transistor de sélection TS1, TS2, ..., TSn à la borne 2 d'application d'un potentiel positif. Les transistors TSi sont, dans cet exemple, des transistors MOS à canal P et reçoivent individuellement un signal de commande sélectionnant le bit considéré de la mémoire. Les bornes des résistances Rpi, opposées aux transistors TSi respectifs, sont connectées ensemble au point 4 relié, par un unique transistor de programmation MN, au potentiel de référence 2. Une résistance de lecture Rb est connectée en parallèle sur le transistor MN. Le noeud 4 est relié à l'une de deux entrées (par exemple, l'entrée inverseuse) d'un amplificateur différentiel 5 constituant un amplificateur de lecture de la mémoire et fournissant, en sortie, l'état de la cellule sélectionnée. L'autre entrée (par exemple, non-inverseuse) de l'amplificateur différentiel 5 est reliée au point milieu 6 d'une association en série d'une résistance de référence Rr et d'une deuxième résistance de lecture Rb' connectées en série entre les bornes 2 et 3.

Les résistances Rb et Rb' sont de même valeurs. La valeur de la résistance Rr est choisie pour être comprise entre la valeur des résistances programmées à l'état 0 (respectivement 1) des cellules mémoire et la valeur des résistances non programmées donnant un état 1 (respectivement 0). Ainsi, comme les résistances Rb et Rb' ont des valeurs identiques, la sortie de l'amplificateur différentiel 5 est différente selon que la résistance Rpi sélectionnée a eu sa valeur diminuée de façon irréversible par programmation conformément à l'invention. Initialement, les résistances Rp étant toutes de valeur supérieure à la valeur de la résistance de référence Rr, le code initial est, dans l'exemple de la figure 5, une suite d'états hauts, pour un amplificateur (comparateur) non inverseur.

Un avantage de l'invention est que la cellule individuelle est compatible avec une sérialisation de différentes cellules comme cela est illustré par la figure 5 ou avec une mise en parallèle des cellules en prévoyant un transistor de programmation pour chaque cellule.

Un autre avantage de l'invention est que le nombre de cycles de lecture n'est pas limité.

Un autre avantage de la présente invention est qu'elle ne nécessite aucune technologie particulière contrairement aux structures de mémoire à programmation unique de type EPROM ou EEPROM.

Un autre avantage de la présente invention est qu'elle n'est pas sensible aux ultraviolets et ne peut donc pas être effacée par ce moyen. Plus généralement, une cellule mémoire programmée selon l'invention est ineffaçable en raison de la diminution irréversible de la résistance opérée.

Selon une variante de réalisation, on peut ajouter un ou plusieurs comparateurs (amplificateurs 5) associés chacun à des ponts diviseurs de référence différents. On obtient alors une mémoire multi-niveaux, le niveau mémorisé dépendant de la valeur (par exemple, I1 ou I2) du courant de programmation appliqué à la résistance Rpi de chaque branche. On prévoit alors plusieurs tensions Vp de programmation (au moins fonctionnellement, par exemple, au moyen de diviseurs résistifs).

Plusieurs cellules mémoires peuvent aussi être associées dans une matrice de cellules pour constituer une mémoire à programmation unique.

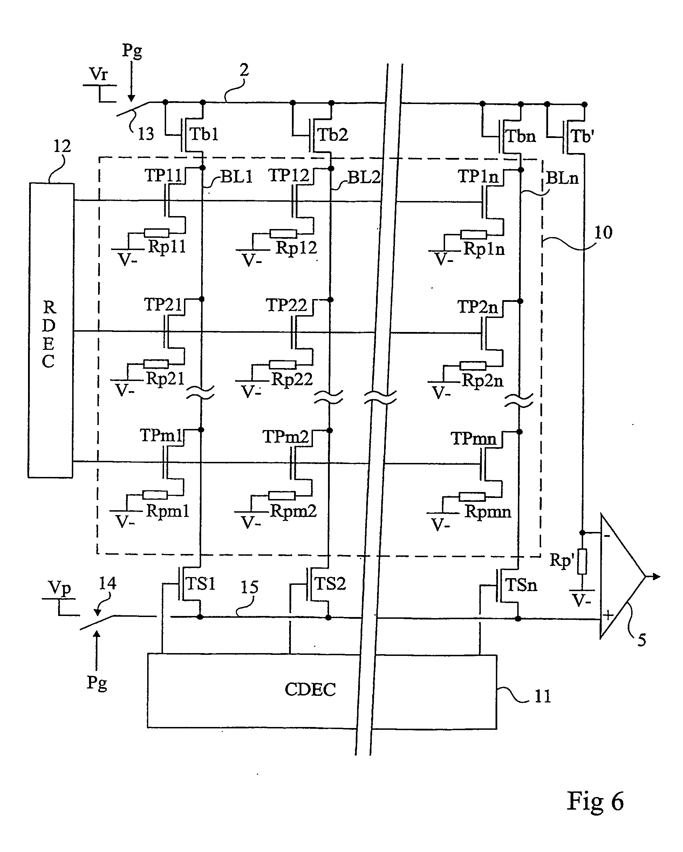

La figure 6 représente un mode de réalisation d'une mémoire à programmation unique illustrant un tel réseau matriciel.

On suppose un réseau 10 de n colonnes et m lignes de cellules mémoires. Chaque cellule mémoire comporte, en série entre une ligne de bits BL1, BL2, ..., BLn et le potentiel V- de référence négative (la masse), un transistor de programmation à canal N TP et une résistance programmable en silicium polycristallin Rp. En figure 6, les transistors de programmation TP et résistances Rp ont été référencés avec le numéro de ligne et de colonne à laquelle ils appartiennent respectivement.

Chaque ligne de bit BL est connectée à la borne 2 d'application d'une tension d'alimentation Valim par l'intermédiaire d'un transistor à canal N Tb1, Tb2, ..., Tbn jouant le rôle de la résistance de charge Rb des modes de réalisation précédents. En pratique, il s'agit de transistors déplétés. Chaque ligne de bit est reliée, par son autre extrémité et par l'intermédiaire d'un transistor de sélection, respectivement Ts1, Ts2, ..., Tsn, à une entrée (par exemple, non inverseuse) d'un amplificateur différentiel 5 de lecture dont la sortie fournit l'état de la cellule lue. L'autre entrée (inverseuse) de l'amplificateur 5 est connectée au point milieu d'un pont diviseur de tension constitué de l'association en série d'un transistor MOS à canal N Tb' connecté à la tension d'alimentation Vr et d'une résistance Rp' connectée à la tension de référence V-.

Les grilles respectives des transistors de sélection TS sont connectées à des sorties individuelles d'un circuit décodeur de colonnes 11 (CDEC) alors que les grilles des transistors de programmation du réseau 10 sont interconnectées, par ligne, à des sorties d'un décodeur de rangées 12 (RDEC). Les décodeurs de rangées 12 et de colonnes 11 ont pour rôle, comme dans un réseau mémoire classique, de sélectionner une des cellules mémoires dont on souhaite lire ou écrire l'état.

De préférence, la résistance Rp' est une résistance également programmable en silicium polycristallin et présente la même valeur nominale issue de fabrication que toutes les résistances du réseau matriciel. De même, les résistances de charge constituées par les transistors Tb et Tb' sont toutes identiques. Lors de la programmation du réseau de cellules mémoire, on commence par programmer la résistance de référence Rp' à une valeur qui est choisie pour être supérieure à la valeur des résistances du réseau quand celles-ci seront programmées dans l'état différent de leur état d'origine. En variante, la résistance Rp' est fixée par dimensionnement à une telle valeur intermédiaire. Toutefois, un avantage de recourir à une programmation de cette résistance est que cela garantit, quelles que soit les éventuelles dispersions de fabrication, un paramétrage correct de la mémoire.

Pour la programmation, la tension d'alimentation est sélectionnée pour être une tension de programmation supérieure à la tension de lecture Vr dans le mode de réalisation représenté en figure 6. En programmation, on ouvre l'interrupteur 13 amenant l'alimentation de lecture sur la ligne 2 et on ferme l'interrupteur 14 amenant la tension de programmation sur la ligne 15 d'interconnexion des transistors de sélection TS. On sélectionne ensuite successivement les cellules dont on souhaite diminuer la valeur de résistance Rp grâce au décodeur de lignes et de colonnes. Les résistances sélectionnées se voient appliquer la tension de programmation par l'intermédiaire du transistor de sélection et du transistor de programmation TP alors en série. Le cas échéant, l'entrée non-inverseuse de l'amplificateur 5 est associée à un moyen de protection, notamment pour le cas où la tension de programmation est supérieure à la tension de lecture Vr. En effet, on notera que le mode de réalisation de la figure 6 est compatible avec le recours à une même tension pour la programmation et la lecture. Cette tension est alors choisie à un niveau suffisant pour imposer la programmation. En lecture, une résistance supplémentaire liée au transistor Tb est ajoutée entre la tension de lecture et le transistor de programmation servant alors de transistor de sélection. Les transistors Tb sont alors dimensionnés pour apporter une résistance série nettement supérieure à celle des transistors de sélection, de façon à imposer une chute de tension suffisante pour éviter une programmation lorsque la tension d'alimentation est appliquée sur la ligne 2 alors que l'on souhaite faire une lecture.

En variante, on pourra prévoir des transistors de sélection de programmation court-circuitant les transistors Tb lors d'une programmation, la tension Vp étant alors appliquée sur la borne 2 et non plus sur les transistors TS qui sont alors seulement interconnectés sur l'entrée non-inverseuse de l'amplificateur 5.

La génération des signaux de commande en programmation Pg des interrupteurs 13 et 14, de même que des signaux de sélection des différentes cellules est à la portée de l'homme du métier à partir des indications fonctionnelles données ci-dessus.

Un autre exemple d'application de la présente invention concerne le blocage d'un circuit intégré suite à la détection d'une tentative de fraude. Des processus de détection de tentatives de fraude sont parfaitement connus. Ils servent à identifier qu'une puce de circuit intégré (par exemple, du type carte à puce prépayée ou non) a subi une attaque pour, soit utiliser les unités prépayées, soit découvrir une clé secrète de la puce. Dans un tel cas, on souhaite invalider le fonctionnement ultérieur de la puce pour éviter que la fraude porte ses fruits. Par la mise en oeuvre de l'invention, il est possible de mémoriser une quantité secrète au moyen d'une mémoire à programmation unique propre à l'invention. Si au cours de la vie du circuit intégré, on détecte une tentative de fraude justifiant l'invalidation de la puce, on provoque automatiquement la programmation d'une ou plusieurs cellules mémoires dans un état inverse. En inversant même un seul bit de la quantité secrète, le système ne pourra plus authentifier la puce correctement, ce qui conduit à un blocage complet et irréversible de la puce.

Pour la programmation d'une mémoire selon l'invention, on pourra dissocier plusieurs phases distinctes dans la vie du produit. Par exemple, on prévoit une première zone (première série de résistances) programmable à l'issue de la fabrication pour contenir un code "fabricant". Le reste de la mémoire est laissé disponible pour être programmé (en une ou plusieurs fois) par l'utilisateur (final ou non).

Bien entendu, la présente invention est susceptible de diverses variantes et modifications qui apparaîtront à l'homme de l'art. En particulier, la transposition d'un montage série tel qu'illustrée par la figure 5 à un montage parallèle est à la portée de l'homme du métier à partir des indications fonctionnelles données ci-dessus. De plus, les dimensions données aux résistances constituant les éléments de mémorisation et aux différentes sources de courant et de tension nécessaires pour la programmation sont à la portée de l'homme du métier à partir des indications fonctionnelles indiquées dans la présente description. Enfin, on notera que l'invention est aisément transposable d'une technologie à une autre.

**Revendications**

1.  Mémoire à programmation unique, comportant :

    une pluralité de cellules mémoires pourvues chacune d'un premier transistor (TS) en série avec une résistance (Rp) en silicium polycristallin constituant l'élément de mémorisation, la programmation étant non destructrice de la résistance en silicium polycristallin, la mémoire comportant au moins un amplificateur différentiel (5) de lecture dont une première entrée est connectée entre au moins une des cellules et un deuxième transistor (MN), et un élément résistif de lecture (Rb), court-circuitable par le deuxième transistor lors d'une programmation des cellules mémoires, étant connecté en parallèle à ce deuxième transistor, la mémoire étant **caractérisée en ce que** la première entrée est connectée entre chacune des cellules et le deuxième transistor et **en ce que** une deuxième entrée (6) de l'amplificateur differentiel reçoit un potentiel de référence intermédiaire entre les états programmés et non programmés des cellules.

2.  Mémoire selon la revendication 1, dans laquelle le potentiel de référence est prélevé au point milieu d'un pont diviseur résistif (Rr, Rb').

3.  Mémoire selon la revendication 1 ou 2, dans laquelle chaque cellule présente un état non programmé qui est, par programmation, modifié en diminuant, de façon irréversible et stable dans la plage de courants de fonctionnement en lecture de la cellule, la valeur de sa résistance en silicium polycristallin (Rp).

4.  Mémoire selon l'une quelconque des revendications 1 à 3, dans laquelle la programmation d'une cellule est commandée en forçant la circulation d'un courant dans sa résistance en silicium polycristallin (Rp) qui soit supérieur au courant pour lequel la valeur de cette résistance présente un maximum.

5.  Mémoire selon l'une quelconque des revendications 1 à 4, dans laquelle plusieurs amplificateurs de lecture reçoivent des tensions de références différentes et sont tous connectés par leur première entrée à plusieurs cellules, de façon à constituer une mémoire multi-niveaux différenciés par les valeurs des - résistances en silicium polycristallin.

**Claims**

1.  A one-time programmable memory, comprising:

    a plurality of memory cells, each provided with a first transistor (TS) in series with a resistor (Rp) in polysilicon, constituting the storage element, the programmation being non destructive for the polysilicon resistor, the memory comprising at least one read differential amplifier (5), a first input of which is connected between at least one of the cells and a second transistor (MN) and a resistive element (Rb), that can be shortcircuited by the second transistor during a programmation of the memory cells, being parallel connected with said second transistor, the memory being **characterized in that** the first input is connected between each cell and the second transistor and **in that** a second input (6) of the differential amplifier receives a reference potential intermediate between the programmed and non programmed states of the cells.

2.  The memory of claim 1, wherein the reference potential is taken at the intermediate point of a resistive dividing bridge (Rr, Rb').

3.  The memory of claim 1 or 2, wherein each cell presents a non programmed state which is, by programmation, modified by decreasing, in an irreversible and stable way in the range of the read operating currents of the cell, the value of its polysilicon resistor (Rp).

4.  The memory of any of claims 1 to 3, wherein the programmation of a cell is controlled by imposing the circulation of a current in its polysilicon resistor (Rp) that is higher than the current for which the value of this resistor presents a maximum.

**5.** The memory of any of claims 1 to 4, wherein a plurality of read amplifiers receives different reference voltages and are connected by their first input to a plurality of cells, so as to constitute a multilevel memory differentiated by the value of the polysilicon resistors.

**Patentansprüche**

**1.** Einmal programmierbarer Speicher, einfassend:

mehrere Speicherzellen, die jeweils mit einem ersten Transistor (TS) in Reihe mit einem Widerstand (Rp) aus Polysilizium, welcher das Speichenelement bildet, vorgesehen sind, wobei die Programmierung des Widerstand aus Polysilizium nicht zerstörend ist, wobei der Speicher wenigstens einen Lese-Differentialverstärker (5), dessen erster Eingang zwischen wenigstens einer der Zellen und einem zweiten Transistor (MN) angeschlossen ist, sowie ein Lese-Widerstandselement (Rb), das bei einer Programmierung der Speicherzellen durch den zweiten Transistor kurzschließbar und zu diesem zweiten Transistor parallel geschaltet ist, aufweist, **dadurch gekennzeichnet, dass** der erste Eingang zwischen jeder der Zellen und dem zweiten Transistor angeschlossen ist und dass ein zweiter Eingang (6) ein Bezugspotential empfängt, das zwischen den programmierten und den nicht-programmierten Zuständen der Zellen liegt.

**2.** Speicher nach Anspruch 1, wobei das Bezugspotential an dem Mittelabgriff einer Ohmschen Teilerbrücke (Rr, Rb') abgenommen wird.

**3.** Speicher nach Anspruch 1 oder 2, wobei jede Zelle einen nicht-programmierten Zustand aufweist, der durch Programmierung modifiziert wird, indem auf irreversible und stabile Weise im Bereich der Lesebetriebsströme der Zelle der Wert seines Widerstands aus Polysilizium (Rp) gesenkt wird.

**4.** Speicher nach einem der Ansprüche 1 bis 3, wobei die Programmierung einer Zelle gesteuert wird, indem die Zirkulation eines Stroms in ihrem Widerstand aus Polysilizium (Rp) erzwungen wird, der höher ist, als der Strom, für welchen der Wert dieses Widerstands ein Maximum aufweist.

**5.** Speicher nach einem der Ansprüche 1 bis 4, wobei mehrere Lese-Verstärker verschiedene Bezugsspannungen empfangen und alle mit ihrem ersten Eingang mit mehreren Zellen verbunden sind, um einen Speicher mit mehreren Ebenen zu bilden, welche sich durch die Werte der Widerstände aus Polysilizium unterscheiden.

Fig 1

Fig 2

Fig 5

Fig 3

Fig 4

Fig 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0511560 A
- JP 54098536 A
- FR 2523357 A
- US 4146902 A
- US 6198678 B